# EUROPEAN PATENT APPLICATION

(11) **EP 4 686 376 A1**
(43) Date of publication of application: **28.01.2026**
(21) Application number: 25189337.6
(22) Date of filing: 14.07.2025
(51) Int. Cl.: H10P 72/00, H10P 72/76, H10P 72/30

(54) **AUTOMATED SYSTEM FOR TESTING A SEMICONDUCTOR SPECIMEN AND CORRESPONDING AUTOMATED METHOD FOR TESTING THE SAME**

(30) Priority: 19.07.2024 KR 20240095634
(71) Applicant: Samsung Electronics Co., Ltd., Suwon-si, Gyeonggi-do 16677 (KR)
(72) Inventor: HAN, Daewoong, 16678 Suwon-si (KR); KIM, Gahee, 16678 Suwon-si (KR); KIM, Jeonghun, 16678 Suwon-si (KR); LEE, Joonhyung, 16678 Suwon-si (KR)
(74) Representative: Elkington and Fife LLP

(57) **Abstract**

An automated system (1) for testing a semiconductor specimen includes: a holder configured to hold the semiconductor specimen; a container configured to hold a reagent; a gripper configured to grip the holder; a robot (20) including an end effector (22) configured to manipulate the gripper between a gripping mode and a release mode; and a test device (100) configured to test the semiconductor specimen, and including: a load area (120) where the container and the holder are loaded; a processing area (130) where the holder is dipped into the reagent within the container using the end effector and rotated to chemically process the semiconductor specimen; a rinsing area (140) where the holder and the semiconductor specimen are rinsed using the gripper connected to the end effector; and a drying area (150) where the holder and the semiconductor specimen are dried using the gripper connected to the end effector. A corresponding method for testing a semiconductor specimen is also disclosed.

## Description

### FIELD OF THE INVENTION

The disclosure relates to an apparatus, a method, and a system for automatically testing a semiconductor specimen.

### BACKGROUND OF THE INVENTION

Experiments to test semiconductor specimens are conducted to identify materials that are optimized for semiconductor processes such as cleaning, photoresist (PR), or chemical mechanical polishing (CMP) processes. The experiments may include a process in which a semiconductor specimen is treated with a reagent, then rinsed and dried. Typically, a researcher manually performs an experiment to test a semiconductor specimen using an experimental device. There has been a growing demand for an automated system to test semiconductor specimens that enables efficient testing of small quantities and sizes of semiconductor wafers and materials in a research environment or laboratory.

### SUMMARY OF THE INVENTION

According to an aspect of the present disclosure, an automated system for testing a semiconductor specimen, may include: a holder configured to hold the semiconductor specimen; a container configured to hold a reagent; a gripper configured to grip the holder; a robot including an end effector configured to manipulate the gripper between a gripping mode in which the gripper grips the holder and a release mode in which the gripper releases the holder; and a test device configured to test the semiconductor specimen, and including: a load area where the container and the holder are loaded; a processing area where the holder is dipped into the reagent within the container using the end effector and rotated to chemically process the semiconductor specimen; a rinsing area where the holder and the semiconductor specimen are rinsed using the gripper connected to the end effector; and a drying area where the holder and the semiconductor specimen are dried using the gripper connected to the end effector.

Proposed embodiments may relate to apparatus for performing a wet etching process to remove a predetermined substance on a substrate and, more particularly, apparatus for automatically dipping in an etching solution, rinsing, and drying a sample substrate manufactured in a coupon type according to a reaction recipe. For example, embodiments may be used to perform processes such as wet etching, development, and the like in developing semiconductor process materials.

Embodiments may therefore be used in various fields such as laboratories, research institutes, and in manufacturing processes that develop semiconductor process materials such as cleaning, photoresist, and chemical mechanical polishing (CMP) materials.

In particular, embodiments may provide a structure for automatically dipping in a reaction solution, rinsing, and drying a sample (20x20mm2 piece wafer specimen) manufactured in a coupon type according to a reaction recipe, to be utilized for research and development of semiconductor process materials. Dipping, rinsing, and drying functions may be performed through an X-Y-Z stage robot provided in an apparatus, and a heating device (heating bath) and a cooling device (cooler) for heating/cooling the reaction solution to a target temperature and an apparatus for supplying/collecting a rinsing solution necessary for rinsing may be provided. Also, a disposable-type gripper may be applied to prevent cross-contamination of various solutions, and an end effector may have a rotation function to use the convection of a fluid to improve the reaction of the coupon and rinsing performance.

The gripper may include: a gripper base configured to be connected to the end effector; a plurality of legs extending from the gripper base in an axial direction and being spaced apart from each other around a perimeter of the gripper base in a circumferential direction; and a pushrod connected to the plurality of legs and configured to push the plurality of legs, in a radial direction from a center of the gripper base towards an edge of the gripper base.

The pushrod may include: a first portion extending from the center of the gripper base in the axial direction; and a plurality of second portions connecting the first portion and the plurality of legs, respectively.

The gripper base may include a base hole, and the first portion of the pushrod passes at least partially through the base hole.

The gripper may include grooves arranged in the plurality of legs, respectively, and configured to engage with the holder.

The holder may include: a holder base; and a recess in one surface of the holder base and configured to arrange the semiconductor specimen therein.

The holder may include an elastically deformable tongue configured to elastically support one side of the semiconductor specimen.

The holder may include a clearance gap arranged on the surface of the holder base and connected to the recess.

The semiconductor specimen may be about 18 millimeters (mm) to about 22 mm in length and width, and about 0.6 mm to about 0.9 mm in thickness.

The processing area may include: a heater configured to increase a temperature in the container; and a cooler configured to decrease the temperature in the container.

The processing area may include a reservoir configured to hold a liquid having a bath temperature.

The heater may include a pipe arranged in the reservoir.

The cooler is configured to generate a vortex in the reservoir.

The automated system may include: a processor; and a memory configured to includes at least one instruction executable by the processor, wherein the at least one instruction includes an instruction to control either one or both of the heater and the cooler to set the bath temperature to be a test temperature.

The processing area may include a level sensor configured to measure a level of the reservoir.

The automated system may include: a processor; and a memory configured to store at least one instruction executable by the processor, wherein the at least one instruction includes an instruction to not supply either one or both of a new container and a new holder to the load area while the semiconductor specimen is being processed in the processing area.

The automated system may include: an optical sensor configured to measure a structure of a surface of the semiconductor specimen.

The automated system may include: a temperature sensor configured to measure a temperature of the reagent.

The gripper is attachable to and detachable from the end effector, and the automated system may further include: a return area where the gripper is discarded by the end effector.

According to an aspect of the present disclosure, an automated method of testing a semiconductor specimen may include: providing a holder configured to hold the semiconductor specimen and a container configured to hold a reagent to a load area; moving the container to a processing area using an end effector; moving the holder to the processing area using the end effector; dipping the holder into the reagent within the container and rotating the holder to chemically process the semiconductor specimen; moving the holder to a rinsing area using the end effector to rinse the semiconductor specimen; and moving the holder to a drying area using the end effector to dry the semiconductor specimen.

### BRIEF DESCRIPTION OF THE DRAWINGS

These and/or other aspects, features, and advantages of the invention will become apparent and more readily appreciated from the following description of embodiments, taken in conjunction with the accompanying drawings of which:
FIG. 1 is a perspective view of an automated system according to one or more embodiments;
FIG. 2 is a view schematically illustrating a load area of a test device according to one or more embodiments;
FIG. 3 is a view schematically illustrating a load area of a test device according to one or more embodiments;
FIG. 4 is a view schematically illustrating a processing area of a test device according to one or more embodiments;
FIG. 5 is a view schematically illustrating a rinsing area of a test device according to one or more embodiments;
FIG. 6 is a view schematically illustrating a drying area of a test device according to one or more embodiments;
FIG. 7 is a view illustrating a semiconductor specimen and a holder of a system according to one or more embodiments;
FIG. 8 is a view illustrating a gripper of a system according to one or more embodiments;
FIG. 9 is a view illustrating a gripper gripping a holder according to one or more embodiments;
FIG. 10 is a block diagram of a system according to one or more embodiments;
FIG. 11 is a flowchart illustrating a method of processing a semiconductor specimen by a system according to one or more embodiments;
FIG. 12 is a view schematically illustrating a gripper coupled to an end effector in the method of FIG. 11 according to one or more embodiments;
FIG. 13 is a view schematically illustrating a gripper gripping a holder in the method of FIG. 11 according to one or more embodiments;
FIG. 14 is a view schematically illustrating an end effector supplying a holder from a load area to a processing area in the method of FIG. 11 according to one or more embodiments;
FIG. 15 is a view schematically illustrating a semiconductor specimen being processed in a processing area in the method of FIG. 11 according to one or more embodiments;
FIG. 16 is a view schematically illustrating a semiconductor specimen being rinsed in a rinsing area in the method of FIG. 11 according to one or more embodiments;
FIG. 17 is a view schematically illustrating a semiconductor specimen being dried in a drying area by a system in the method of FIG. 11 according to one or more embodiments;
FIG. 18 is a view schematically illustrating a processing area where a semiconductor specimen is processed with a developer according to one or more embodiments; and
FIG. 19 is a view schematically illustrating a processing area where a semiconductor specimen is processed with an abrasive according to one or more embodiments.

### DETAILED DESCRIPTION

Hereinafter, embodiments will be described in detail with reference to the accompanying drawings. However, various alterations and modifications may be made to the embodiments. Here, the embodiments are not meant to be limited by the descriptions of the present disclosure. The embodiments should be understood to include all changes, equivalents, and replacements within the idea and the technical scope of the disclosure.

The terminology used herein is for the purpose of describing particular embodiments only and is not intended to be limiting. The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

Unless otherwise defined, all terms including technical and scientific terms used herein have the same meaning as commonly understood by one of ordinary skill in the art to which the embodiments belong. Terms, such as those defined in commonly used dictionaries, are to be interpreted as having a meaning that is consistent with their meaning in the context of the relevant art and the present disclosure, and are not to be interpreted in an idealized or overly formal sense unless expressly so defined herein.

When describing the embodiments with reference to the accompanying drawings, like reference numerals refer to like components and a repeated description related thereto will be omitted. In the description of embodiments, detailed description of well-known related structures or functions will be omitted when it is deemed that such description will cause ambiguous interpretation of the present disclosure.

Also, in the description of the components, terms such as first, second, A, B, (a), (b) or the like may be used herein when describing components of the present disclosure. These terms are used only for the purpose of discriminating one component from another component, and the nature, the sequences, or the orders of the components are not limited by the terms. It should be noted that if one component is described as being "connected," "coupled" or "joined" to another component, the former may be directly "connected," "coupled," and "joined" to the latter or "connected", "coupled", and "joined" to the latter via another component.

The same name may be used to describe an element included in the embodiments described above and an element having a common function. Unless otherwise mentioned, the descriptions of the examples may be applicable to the following examples and thus, duplicated descriptions will be omitted for conciseness.

Herein, one of ordinary skill in the art would appreciate that the terms "substantially", "approximately", "generally", and "about" used to describe given parameters, properties, or conditions indicate that the given parameters, properties, or conditions are satisfied with a small degree of variance such as within an acceptable manufacturing tolerance. For example, a specific parameter that is substantially satisfied may be satisfied at least 90%, at least 95%, or at least 99%.

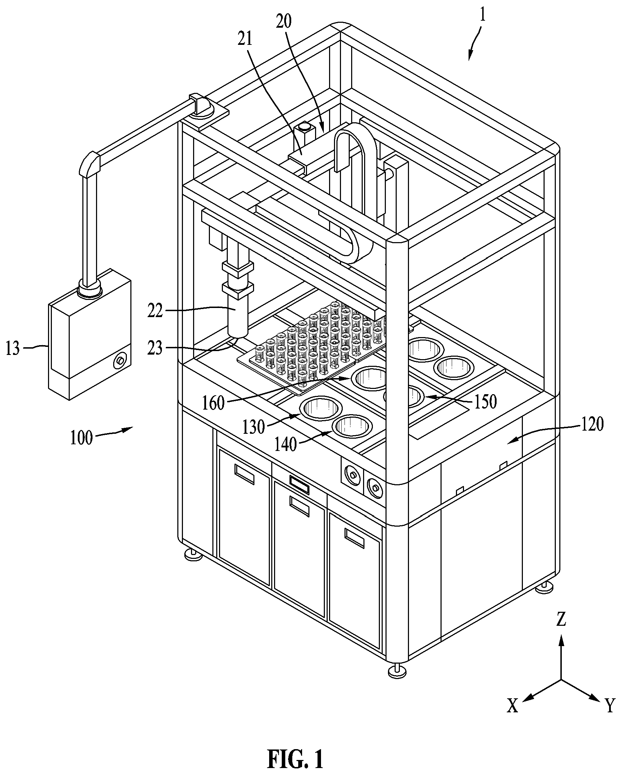

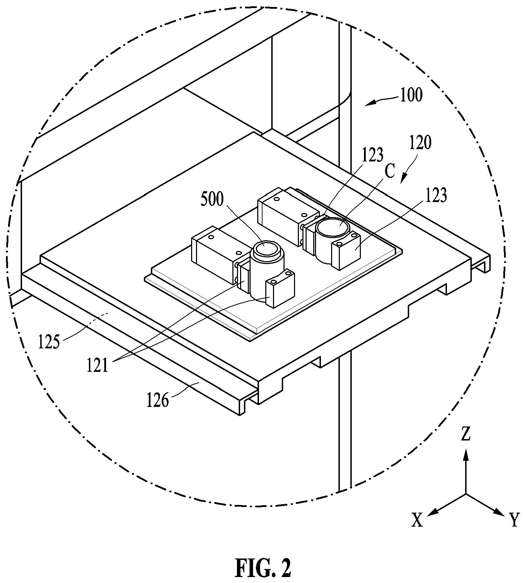

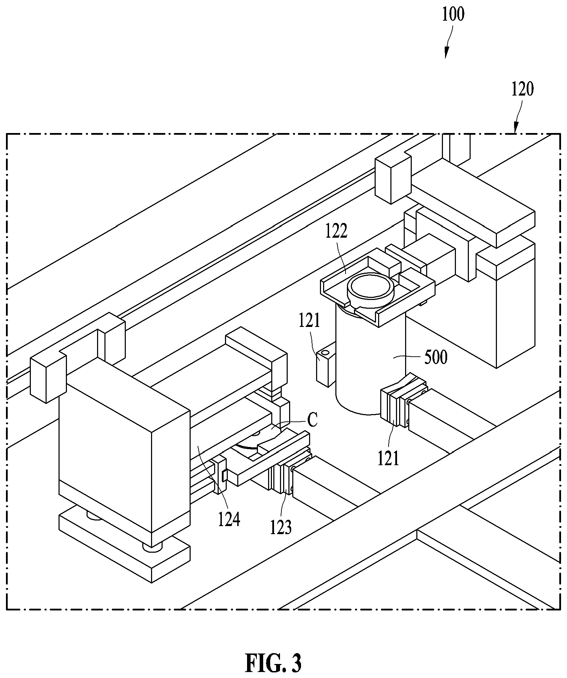

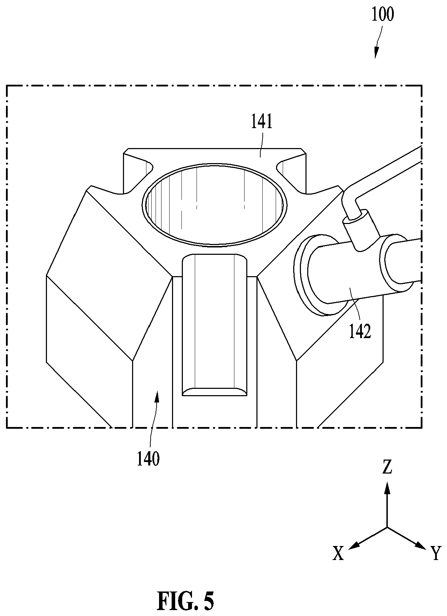

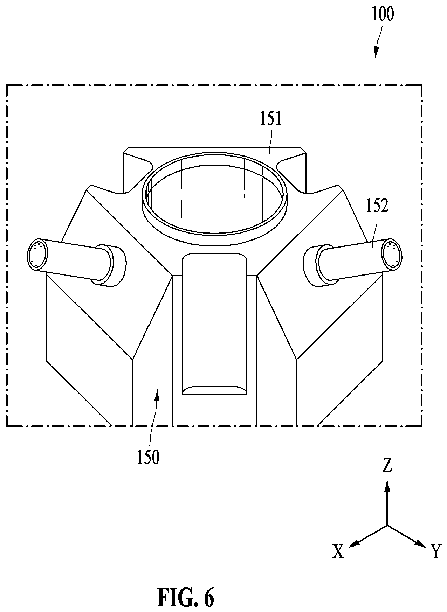

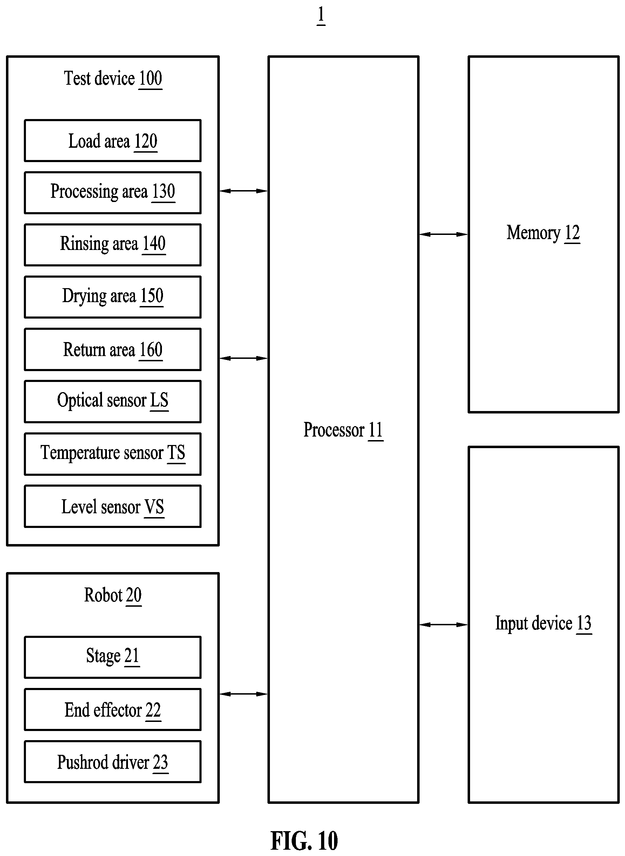

Referring to FIGS. 1 to 6 and FIG. 10, a system 1 may automatically perform an experiment to test a semiconductor specimen 200 to find a material optimized for semiconductor processes such as cleaning, photoresist, or chemical mechanical polishing (CMP) processes. The system 1 may include a test device 100, a robot 20, a processor 11, a memory 12, and an input device 13.

The testing device 100 may include a load area 120, a processing area 130, a rinsing area 140, a drying area 150, a return area 160, an optical sensor LS, a temperature sensor TS, and a level sensor VS.

The robot 20 may include a stage 21, an end effector 22, and a pushrod driver 23.

The processor 11 may execute instructions stored in the memory 12 and operate the test device 100 to automatically test the semiconductor specimen 200 according to instructions stored in a memory 12. The system 1 may test the semiconductor specimen 20 under various conditions (e.g., temperature, processing time, etc.). The system 1 may repeatedly obtain test results by repeatedly testing semiconductor specimens under the same conditions. The system 1 may reduce or eliminate errors and uncertainties in experimental results that may arise from human intervention.

The input device 13 may interact with the processor 11 to provide user instructions to the processor 11.

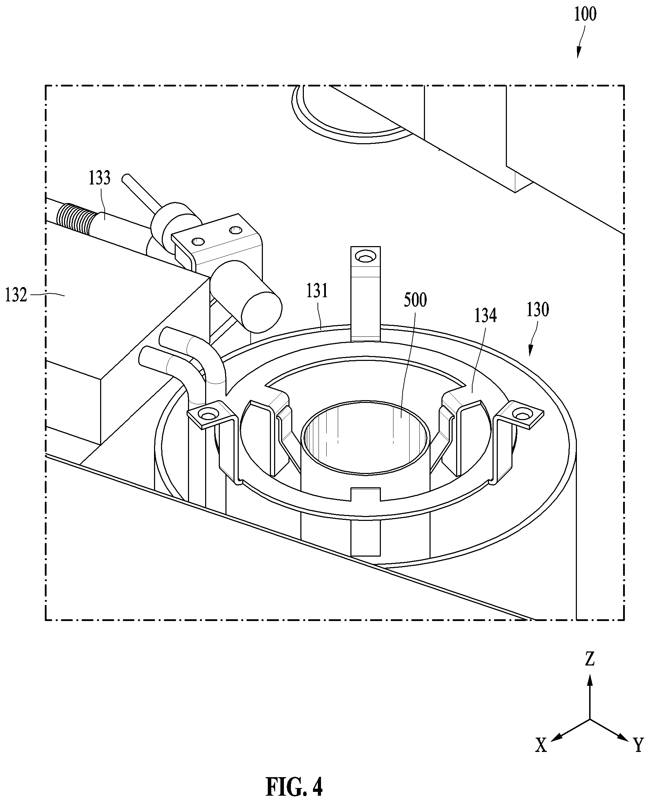

The memory 12 may include an instruction to not supply a new container and/or a new holder 300 to the load area 120 while the semiconductor specimen 200 is being processed in the processing area 130. The memory 12 may include an instruction to adjust the amount of liquid held in a reservoir 131 (e.g., the reservoir 131 shown in FIG. 4) based on the level of the reservoir 131 measured by the level sensor VS to prevent an overflow of the liquid. The memory 12 may include an instruction to set the bath temperature or the temperature of a container 500 and/or a reagent to a desired temperature (e.g., a test temperature input through an input device 13) by controlling a heater 132 and/or a cooler 133. The memory 12 may include an instruction to stop the heater 132 from further increasing the temperature of the liquid and/or reagent when the temperature of the liquid and/or reagent reaches a predetermined temperature. The memory 12 may include an instruction to stop the cooler 133 from further decreasing the temperature of the liquid and/or reagent when the temperature of the liquid and/or reagent lowers and reaches a predetermined temperature.

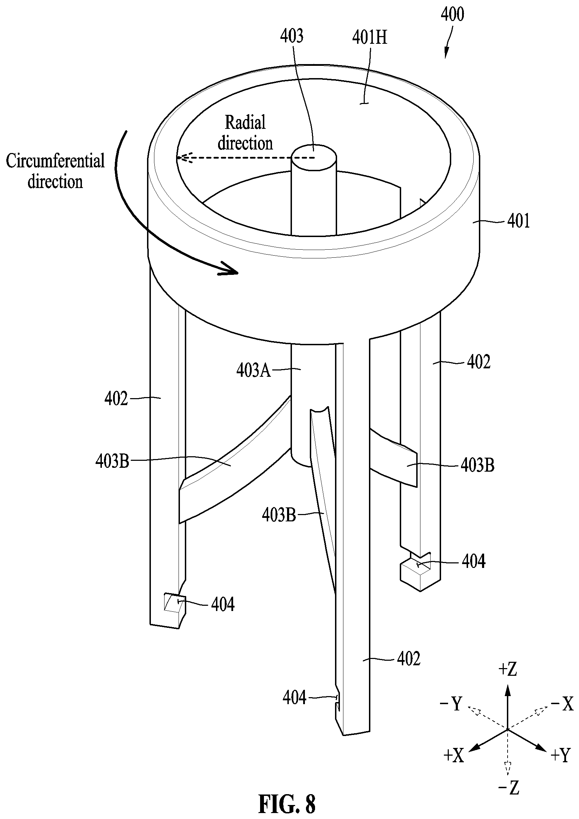

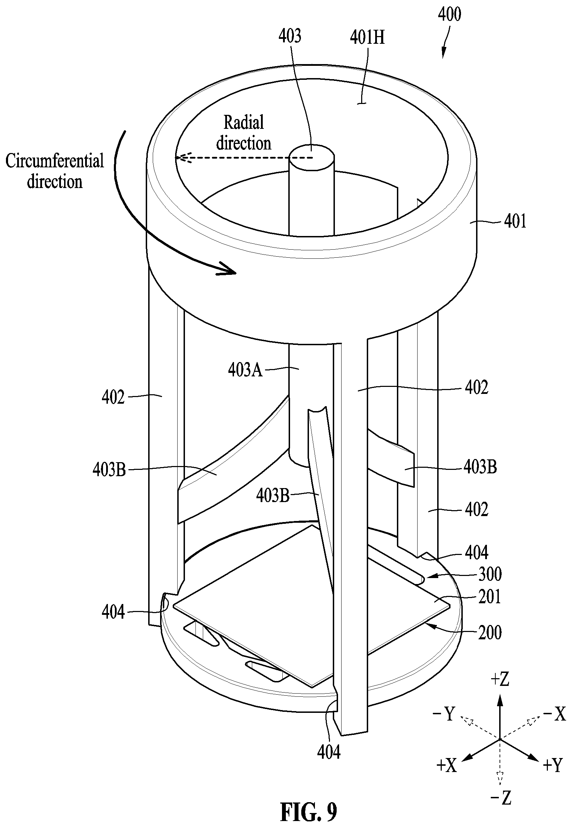

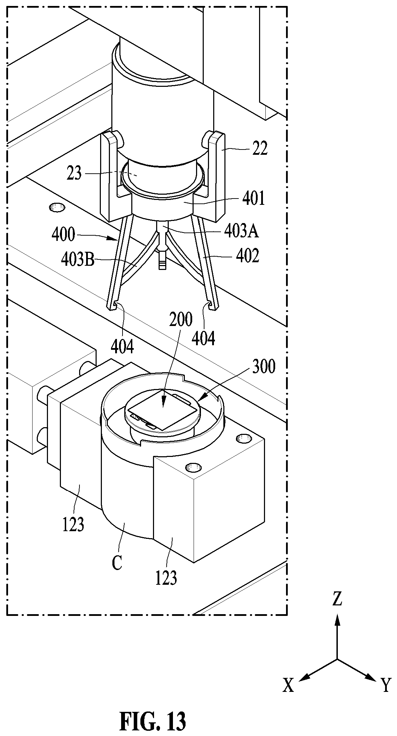

The memory 12 may include an instruction to cause an end effector 22 to manipulate a gripper 400 between a gripping mode, where the gripper 400 holds the holder 300, and a release mode, where the gripper 400 release the holder 300. In the gripping mode, the gripper 400 may have a grip form shown in FIGS. 8 and 9, and in the release mode, the gripper 400 may take on a release form shown in FIG. 13.

The input device 13 may receive experimental conditions input from an experimenter. Information received by the input device 13 may be stored in the memory 12. The input device 13 may include a button, a keypad, a switch, a touch panel, and the like, but is not limited thereto.

The robot 20 may move the semiconductor specimen 200, the holder 300, the gripper 400, and/or the container 500. The robot 20 may include the end effector 22 configured to grip the gripper 400 and/or the container 500, and a stage 21 configured to move the end effector 22. The stage 21 may be a three-axis linear stage configured to move the end effector 22 along three perpendicular axes. The stage 21 may be configured to translate the end effector 22 on three axes (e.g., X-axis, Y-axis, and Z-axis). The end effector 22 may be configured to rotate about the substantial center axis (e.g., Z-axis) of the end effector 22. The end effector 22 may rotate together with the gripper 400 while gripping the gripper 400. Accordingly, the end effector 22 may rotate the semiconductor specimen 200 and/or the holder 300.

The end effector 22 may be connected to the pushrod driver 23. The pushrod driver 23 may be configured to manipulate the gripper 400 between the gripping mode (e.g., the form of the gripper 400 in FIGS. 8 and 9) in which the gripper 400 grips the holder 300 in response to driving of a pushrod 403 and the release mode (e.g., the form of the gripper 400 in FIG. 13) in which the gripper 400 releases the holder 300. In one or more embodiments, while the gripper 400 is attachable to and detachable from the end effector 22, when attached, the gripper 400 may be considered as a part of the end effector 22. Also, in one or more embodiments, the pushrod driver 23 may be considered as a part of the end effector 22, so that the end effector 22 is understood as including the pushrod driver 23 and the gripper 400.

The test device 100 may include the load area 120 configured to load the holder 300 and/or the container 500. The load area 120 may accommodate the holder 300 and/or the container 500 and supply the holder 300 and/or the container 500 to the inside of the test device 100.

The load area 120 may include a container support 121 configured to support the container 500. The container support 121 may protrude from the base surface (e.g., the surface in the +Z normal direction) of the load area 120 and support sides of the container 500. The container 500 may be inserted into the container support 121. The load area 120 may include a container cap remover 122. The container cap remover 122 may separate the cap of the container 500 loaded by the load area 120 from the container 500.

The load area 120 may include a case support 123 supporting a case C configured to accommodate a semiconductor specimen. The case support 123 may protrude from the base surface (e.g., the surface in the +Z normal direction) of the load area 120 and support sides of the case C. The case C may be inserted into the case support 123. The load area 120 may include a case cap remover 124. The case cap remover 124 may be configured to separate the cap of the case C loaded by the load area 120 from the case C. The case cap remover 124 may be configured to couple the cap of the case C to the case C.

The load area 120 may include a rail 125, and a slider 126 configured to slide with respect to the rail 125. The rail 125 may be arranged on a side (e.g., the side in the +X direction or the side in the -X direction) of the load area 120. The load area 120 may move to the inside and outside of the test device 100 as the slider 126 slides with respect to the rail 125. In an embodiment, the load area 120 may move to the inside and outside of the test device 100 in various manners other than the sliding manner.

The test device 100 may include the processing area 130 configured to process the semiconductor specimen 200 physically and/or chemically. Processing the semiconductor specimen 200 may include etching, developing, or polishing the semiconductor specimen 200. The semiconductor specimen 200 may be dipped in the reagent (e.g., an etching agent, a developer, an abrasive, or a slurry) to be processed physically and/or chemically.

The processing area 130 may be configured to process the semiconductor specimen 200 at a desired temperature. The processing area 130 may include the reservoir 131 configured to hold a liquid having the bath temperature. The processing area 130 may be configured to increase or decrease the amount of liquid held in the reservoir 131.

The test device 100 may include the level sensor VS configured to measure the level of the liquid (e.g., water) held in the reservoir 131. The level sensor VS may be configured to transmit the measured level directly to the processor 11, or to the memory 12 so that the processor 11 may retrieve the stored level information from the memory 12.

The processing area 130 may include the heater 132. The heater 132 may be configured to increase the temperature of the liquid held in the reservoir 131 and/or the container 500. The heater 132 may heat the liquid and/or the container 500 to increase the temperature of the liquid and/or reagent to a desired temperature. The heater 132 may include a pipe arranged in the reservoir 131.

The processing area 130 may include the cooler 133. The cooler 133 may be configured to generate a vortex in the reservoir 131. The cooler 133 may be configured to decrease the temperature of the liquid held in the reservoir 131 and/or the container 500. The cooler 133 may cool the liquid and/or the container 500 to decrease the temperature of the liquid and/or reagent to a desired temperature.

The test device 100 may include the temperature sensor TS configured to measure the temperature of the liquid held in the reservoir 131, the container 500, and/or the reagent. The temperature sensor TS may be configured to transmit the measured temperature to the processor 11.

The processing area 130 may include a container fixture 134 configured to secure the container 500. The container 500 secured to the container fixture 134 and the reagent may be adjusted to have a desired temperature in the processing area 130. The container 500 may be secured to the container fixture 134 and at least partially immersed in the liquid held in the reservoir 131. The temperature of the container 500 and the reagent may be adjusted by double boiling. Double boiling may reduce or prevent a radical change in the temperature of the reagent.

In an embodiment, the temperature of the reagent may be implemented in various manners other than double boiling in the processing area 130. For example, the heater 132 or the cooler 133 may directly touch the container 500 to adjust the temperature of the reagent.

The test device 100 may include the rinsing area 140 configured to rinse the semiconductor specimen 200. The rinsing area 140 may include a rinsing tank 141 in which the semiconductor specimen 200 is placed and a rinsing liquid sprayer 142 configured to spray a rinsing liquid (e.g., water). The rinsing liquid sprayer 142 may spray the rinsing liquid toward the semiconductor specimen 200 and/or the inside of the rinsing tank 141.

The test device 100 may include the drying area 150 configured to dry the semiconductor specimen 200. The drying area 150 may include a drying tank 151 where the semiconductor specimen 200 is dried and a gas sprayer 152. The gas sprayer 152 may spray a gas (e.g., nitrogen) toward the semiconductor specimen 200 and/or the inside of the drying tank 151.

The test device 100 may include the return area 160 where the gripper 400 is discarded. The end effector 22 may supply the semiconductor specimen 200 dried in the drying area 150 to the load area 120 and then return the used gripper 400 to the return area 160. The gripper 400 used in an experiment for processing the semiconductor specimen 200 may be discarded after use to prevent contamination, rather than being reused. The system 1 may use a new gripper 400 for each experiment and return the used gripper to the return area 160. A new gripper used in a new experiment is free of the reagent and/or rinsing liquid used in the previous experiment and thus, may eliminate the effect of the reagent and/or rinsing liquid used in the previous experiment on experimental results.

The test device 100 may include the optical sensor LS configured to measure the structure of the surface of the semiconductor specimen 200. The optical sensor LS may be arranged in the load area 120. The optical sensor LS may be configured to measure the structure of the surface before and/or after the semiconductor specimen 200 is processed. Meanwhile, the optical sensor LS is described as being arranged in the load area 120, but embodiments are not limited thereto. For example, the optical sensor LS may be arranged in the processing area 130. The optical sensor LS arranged in the processing area 130 may be configured to measure the structure of the surface of the semiconductor specimen 200 in real time while the semiconductor specimen 200 is being processed. A plurality of optical sensors LS may be arranged in different positions (e.g., the load area 120, the processing area 130, etc.).

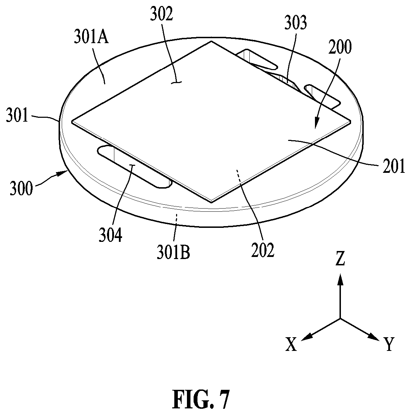

Referring to FIGS. 7 to 9, the system 1 may include the holder 300 configured to hold the semiconductor specimen 2000. The semiconductor specimen 200 may fit in the holder 300. The semiconductor specimen 200 may include a first surface 201 to be mainly processed in the processing area, and a second surface 202 opposite to the first surface 201.

The semiconductor specimen 200 may be in shape and size suitable for use in an experiment to find a material optimized for semiconductor processes. Using a semiconductor specimen 200 smaller than a standardized semiconductor process material for the experiment may reduce the cost of finding materials optimized for semiconductor processes.

For example, the first surface 201 may have a square shape. The first surface 201 may be about 18 millimeters (mm) or more or about 19 mm or more in length (e.g., the X-direction dimension) and width (e.g., the Y-direction dimension). The first surface 201 may be about 20 mm in length (e.g., the X-direction dimension) and width (e.g., the Y-direction dimension). The first surface 201 may be about 21 mm or less or about 22 mm or less in length (e.g., the X-direction dimension) and width (e.g., the Y-direction dimension). The semiconductor specimen 200 may be about 0.6 mm or more or about 0.7 mm or more in thickness (e.g., the Z-direction dimension). The semiconductor specimen 200 may be about 0.8 mm or less or about 0.9 mm or less in thickness (e.g., the Z-direction dimension).

The holder 300 may be configured to hold the semiconductor specimen 200 inside the holder 300. The holder 300 may include a holder base 301. The holder base 301 may be placed to be in close contact or direct contact with the gripper 400. A first-direction thickness (e.g., the Z-direction dimension) of the holder base 301 may be substantially equal to or less than a first-direction length (e.g., the Z-direction dimension) of grooves 404 of the gripper 400.

The holder base 301 may include a first base surface 301A (e.g., the surface oriented in the +Z normal direction) a second base surface 301B, which is opposite to the first base surface 301A. The holder 300 may include a recess 302 that is recessed from the first base surface 301A to the second base surface 301B. The semiconductor specimen 200 may be placed in the recess 302. When the semiconductor specimen 200 is placed in the recess 302, the first surface 201 and the first base surface 301A may lie on substantially the same plane.

The holder 300 may include an elastically deformable tongue 303 configured to elastically support one side (e.g., the side in the -X normal direction) of the semiconductor specimen 200. The tongue 303 may be arranged on an inner side of the holder base 301. When the semiconductor specimen 200 is inserted to be held in the holder 300, the semiconductor specimen 200 may be placed in the recess 302 while pushing the tongue 303, and the semiconductor specimen 200 may be secured in the recess 302 as the tongue 303 supports the side of the semiconductor specimen 200 placed in the recess 302.

The holder 300 may include a clearance gap 304. The clearance gap 304 may be arranged on the first base surface 301A. The clearance gap 304 may be connected to the recess 302. The clearance gap 304 may penetrate through the first base surface 301A and the second base surface 301B. When separating the semiconductor specimen 200 from the holder 300, the semiconductor specimen 200 may be separated from the holder 300 by pushing the semiconductor specimen 200 in a direction from the clearance gap 304 toward the tongue 303. In an embodiment not shown, the clearance gap 304 may be recessed in a direction from the first base surface 301A toward the second base surface 301B, rather than penetrating through the first base surface 301A and the second base surface 301B.

The system 1 may include the gripper 400 configured to grip a holder. When the gripper 400 grips the holder 300, the gripper 400 may not touch the semiconductor specimen 200. The first surface 201 of the semiconductor specimen 200 may be processed, rinsed, and/or dried without any portion covered by the gripper 400 during the experiment. The gripper 400 may have the grip form (e.g., the form of the gripper 400 in FIGS. 8 and 9) to grip the holder 300 and the release form (e.g., the form of the gripper 400 in FIG. 13) to release the holder 300.

The gripper 400 may include a gripper base 401 configured to connect to or be coupled with the end effector 22. The gripper base 401 may include a base hole 401H arranged at the center thereof. The gripper base 401 may have a shape tailored to fit the end effector 22. For example, when the end effector 22 has a shape for gripping a cylindrical container 500, the gripper base 401 may have a cylindrical shape.

The gripper 400 may include a plurality of legs 402 configured to support the holder 300. The plurality of legs 402 may be configured to at least partially elastically deform. The plurality of legs 402 may be configured in close contact or direct contact with the holder base 301. The components of the gripper 400 may be arranged to have a cylindrical shape. For example, the legs 402 may extend from the gripper base 401 in a first direction (e.g., the axial direction of the -Z direction). The plurality of legs 402 may include three or more legs. The plurality of legs 402 may be spaced apart from each other in a second direction (e.g., the circumferential direction around the perimeter of the gripper base 401) orthogonal to the first direction. The plurality of legs 402 may be arranged on the circumference of the gripper base 401. The plurality of legs 402 may be equidistantly spaced apart from each other.

The gripper 400 may include the pushrod 403 configured to push the plurality of legs 402 by being driven by the pushrod driver 23. The pushrod 403 may elastically deform the legs 402. The pushrod 403 may include a first portion 403A extending from the substantial center axis (e.g., the Z-axis) of the gripper base 401 in the first direction (e.g., the -Z direction), and a plurality of second portions 403B connecting the first portion 403A and the legs 402, respectively. The first portion 403A may at least partially pass through the base hole 401H.

When the pushrod driver 23 drives the pushrod 403, the first portion 403A may move in the first direction (e.g., the -Z direction), and the second portions 403B may elastically deform the legs 402, respectively, in a third direction (e.g., the radial direction with respect to the substantial center axis (the Z-axis) of the gripper 400). The legs 402 may move in the third direction, and the gripper 400 may be in the release form (e.g., the form of the gripper 400 in FIG. 13).

When the pushrod 403 returns, the first portion 403A may move in a direction (e.g., the +Z direction) opposite to the first direction, the legs 402 may return in a direction opposite to the third direction (e.g., the radial direction with respect to the substantial center axis (the Z-axis) of the gripper 400), and the gripper 400 may be in the grip form (e.g., the form of the gripper 400 in FIGS. 8 and 9). In the grip form, the plurality of legs 402 may be substantially parallel to each other.

The gripper 400 may include the plurality of grooves 404 configured to engage with the holder 300. The grooves 404 may be arranged in the plurality of legs 402, respectively. The plurality of grooves 404 may be formed on inner surfaces (e.g., the surface facing the central axis (e.g., the Z-axis) of the gripper 400) of the plurality of legs 402, respectively. When the gripper 400 is in the grip form, the circumferential portion of the holder base 301 may be arranged in the plurality of grooves 404. The semiconductor specimen 200 may not be positioned within the plurality of grooves 404. The semiconductor specimen 200 may be positioned near the plurality of grooves 404 without making direct contact with them.

The system 1 may include the container 500 holding the reagent. The reagent may include a material used for semiconductor processes.

For example, the reagent may include an etching agent. The reagent may include a developer. The reagent may include an abrasive.

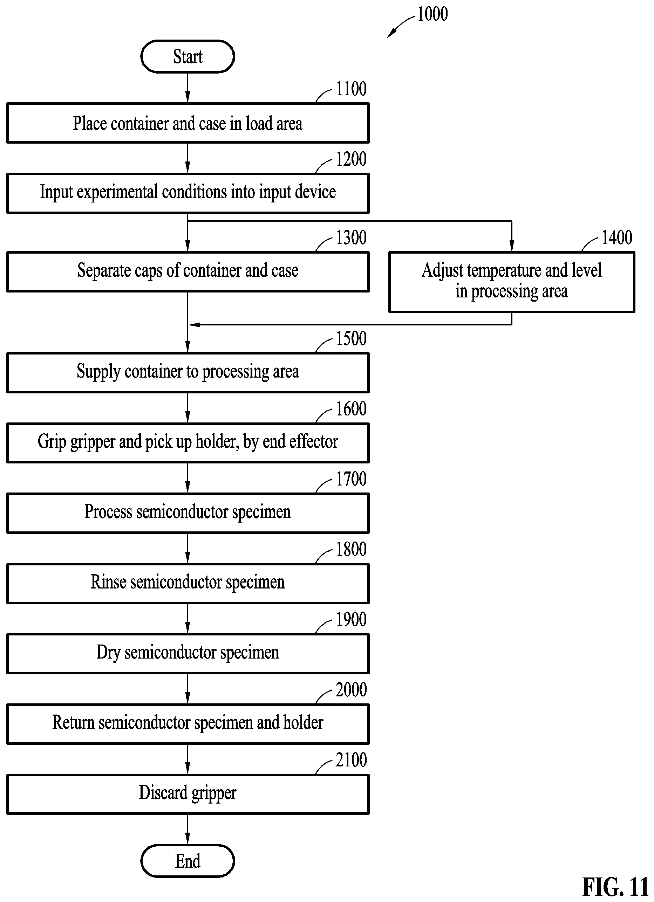

FIGS. 11 to 17 illustrate a method of testing a semiconductor specimen 200 using the system 1. In operation 1100, the container 500 and the case C are placed into the load area 120 of the test device 100. The container 500 may hold a reagent (e.g., an etching agent), and the case C may contain the holder 300 which holds the semiconductor specimen 200. In operation 1200, the input device 13 may receive a user input including experimental conditions and stores the experimental conditions in the memory 12.

According to the input experimental conditions stored in the memory 12, the system 1 may automatically perform an experiment. The load area 120 may move to the inside of the test device 100, the cap of the container 500 may be separated from the container 500, the cap of the case C may be separated from the case C, in operation 1300. The heater 132 and the cooler 133 may adjust the temperature of the liquid and/or reagent in the processing area 130, in operation 1400.

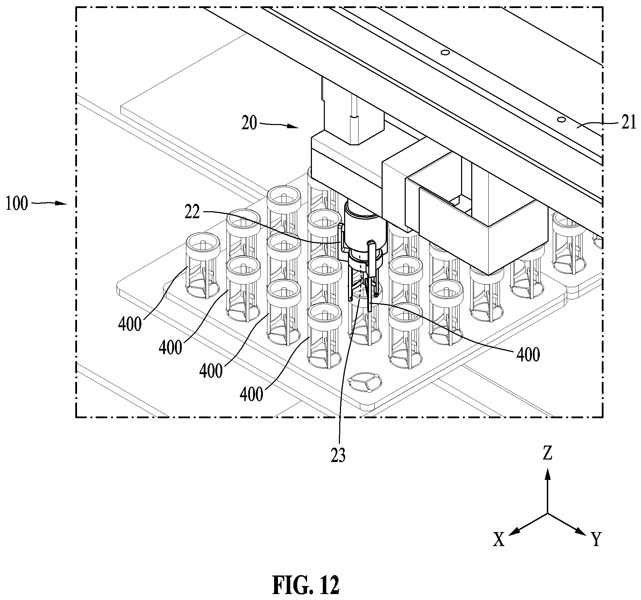

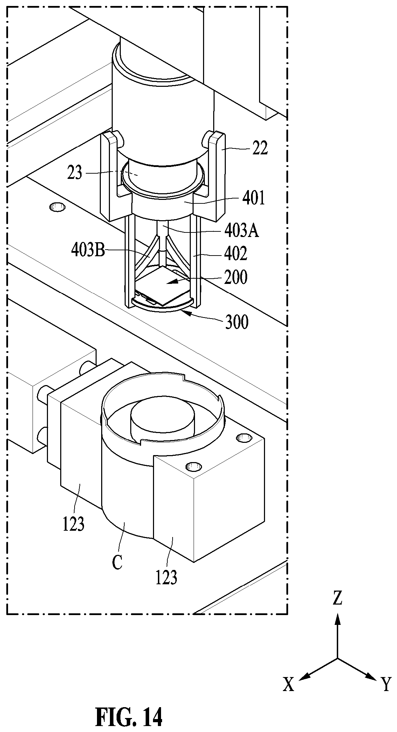

The end effector 22 may grip the container 500 and supply the container 500 from the load area 120 to the processing area 130, in operation 1500. The end effector 22 may grip the gripper 400 and pick up the holder 300 held in the case C, in operation 1600. The process of picking up the holder 300 can be understood through FIGS. 12 to 14. The end effector 22 gripping the gripper 400 may be moved by the stage 21 so that the gripper 400 may be placed on the holder 300 (see FIGS. 12 and 13). The pushrod driver 23 may drive the pushrod 403 so that the gripper 400 may be in the release form (see FIG. 13). The stage 21 may move the end effector 22 in the first direction (e.g., the -Z direction) so that the gripper 400 may come close to the holder 300, and when the plurality of grooves 404 are arranged near the holder base 301, the pushrod driver 23 and the pushrod 403 may cause the gripper 400 to be in the grip form (see FIG. 14). The gripper 400 in the grip form may grip the holder 300.

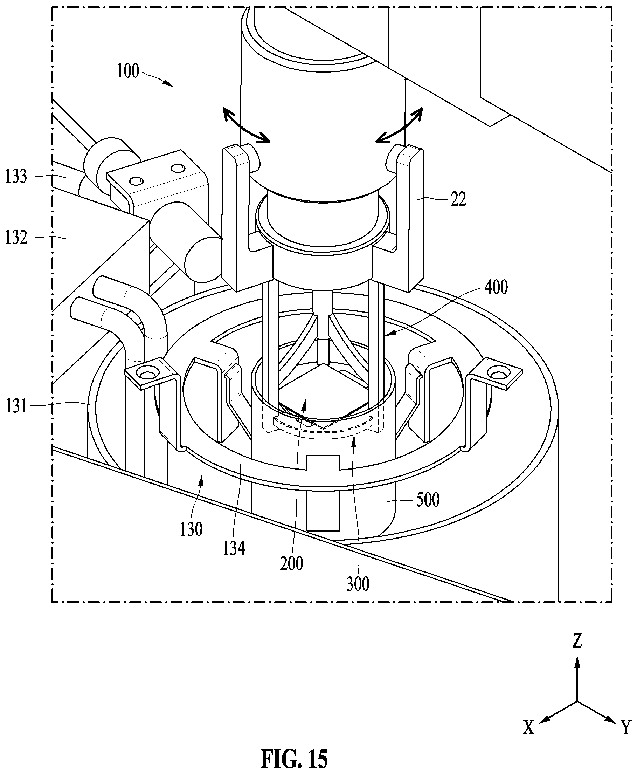

The end effector 22 may dip the picked-up holder 300 in the reagent in the container 500 to process (e.g., etch) the semiconductor specimen 200, in operation 1700 (see FIG. 15). The end effector 22 may be configured to repeatedly move the semiconductor specimen 200 and the holder 300 in the first direction (e.g., the -Z direction) and the direction opposite to the first direction to process the semiconductor specimen 200. The end effector 22 may be configured to rotate about the center axis (e.g., the Z-axis) of the end effector 22 to rotate the semiconductor specimen 200 and the holder 300 and process the semiconductor specimen 200.

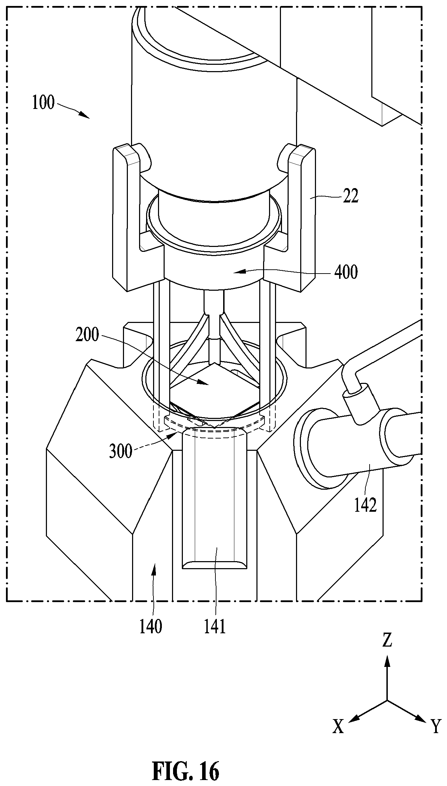

The end effector 22 may supply the processed semiconductor specimen 200 and the holder 300 from the processing area 130 to the rinsing area 140 through the gripper 400. The end effector 22 may place the semiconductor specimen 200 in the rinsing tank 141, and the rinsing liquid sprayer 142 may spray a rinsing liquid to the rinsing tank 141 and the semiconductor specimen 200 to rinse the semiconductor specimen 200, in operation 1800 (see FIG. 16). The end effector 22 may be configured to repeatedly move the semiconductor specimen 200 and the holder 300 in the first direction (e.g., the -Z direction) and the direction opposite to the first direction to rinse the semiconductor specimen 200. The end effector 22 may be configured to rotate about the center axis (e.g., the Z-axis) of the end effector 22 to rotate the semiconductor specimen 200 and the holder 300 and rinse the semiconductor specimen 200.

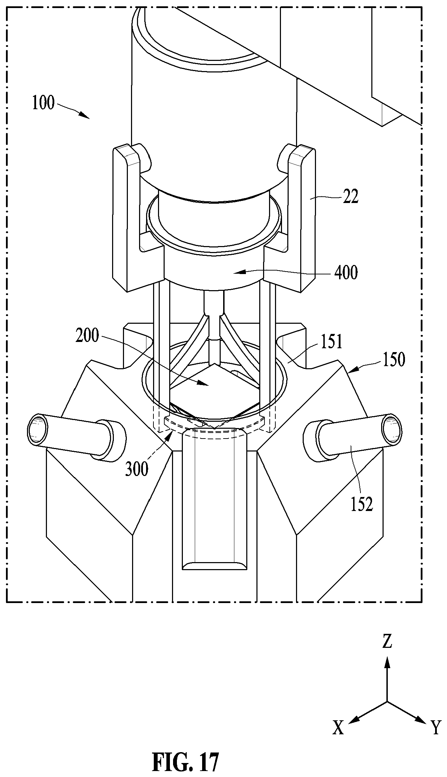

The end effector 22 may supply the rinsed semiconductor specimen 200 and the holder 300 from the rinsing area 140 to the drying area 150 through the gripper 400. The end effector 22 may place the semiconductor specimen 200 in the drying tank 151, and the gas sprayer 152 may spray a gas to the drying tank 151 and the semiconductor specimen 200 to dry the semiconductor specimen 200, in operation 1900 (see FIG. 17). The end effector 22 may be configured to repeatedly move the semiconductor specimen 200 and the holder 300 in the first direction (e.g., the -Z direction) and the direction opposite to the first direction to dry the semiconductor specimen 200. The end effector 22 may be configured to rotate about the center axis (e.g., the Z-axis) of the end effector 22 to rotate the semiconductor specimen 200 and the holder 300 and dry the semiconductor specimen 200.

The end effector 22 may supply the dried semiconductor specimen 200 and the holder 300 to the load area 120, in operation 2000. The end effector 22 may move to the return area 160 and discard the used gripper 400 in the return area 160, in operation 2100. The container 500 and case C supplied to the load area 120 may be recapped and returned to the outside of the test device 100 through the load area 120.

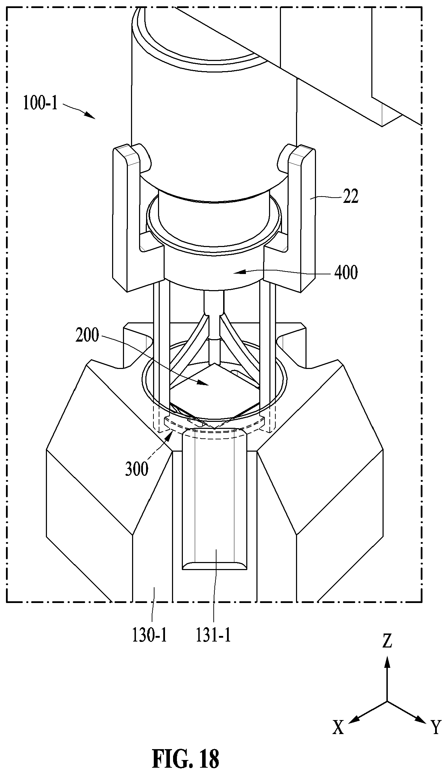

Referring to FIG. 18, a test device 100-1 may include a processing area 130-1 configured to develop a semiconductor specimen 200. The processing area 130-1 may include a reservoir 131-1 configured to accommodate a liquid having the bath temperature and/or a developer. The processing area 130-1 may be configured to develop the semiconductor specimen 200 and/or the holder 300 supplied by the end effector 22. The end effector 22 may dip the picked-up holder 300 in the developer accommodated in the reservoir 131-1 to develop the semiconductor specimen 200.

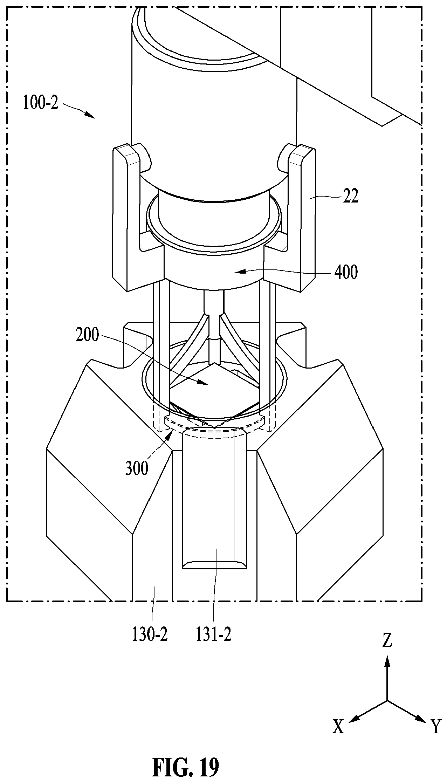

Referring to FIG. 19, a test device 100-2 may include a processing area 130-2 configured to polish a semiconductor specimen. The processing area 130-2 may include a reservoir 131-2 configured to accommodate a liquid having the bath temperature and/or an abrasive. The processing area 130-2 may be configured to polish the semiconductor specimen 200 and/or the holder 300 supplied by the end effector 22. The end effector 22 may dip the picked-up holder 300 in the abrasive accommodated in the reservoir 131-2 to polish the semiconductor specimen 200.

The methods according to the above-described embodiments may be recorded in non-transitory computer-readable media including program instructions to implement various operations of the above-described embodiments. The media may also include, alone or in combination with the program instructions, data files, data structures, and the like. The program instructions recorded on the media may be those specially designed and constructed for the purposes of embodiments, or they may be of the kind well-known and available to those having skill in the computer software arts. Examples of non-transitory computer-readable media include magnetic media such as hard disks, floppy disks, and magnetic tape; optical media such as CD-ROM discs, DVDs, and/or Blue-ray discs; magneto-optical media such as optical discs; and hardware devices that are specially configured to store and perform program instructions, such as read-only memory (ROM), random access memory (RAM), flash memory (e.g., USB flash drives, memory cards, memory sticks, etc.), and the like. Examples of program instructions include both machine code, such as produced by a compiler, and files containing higher-level code that may be executed by the computer using an interpreter. The above-described hardware devices may be configured to act as one or more software modules in order to perform the operations of the above-described examples, or vice versa.

The software may include a computer program, a piece of code, an instruction, or some combination thereof, to independently or uniformly instruct or configure the processing device to operate as desired. Software and data may be embodied permanently or temporarily in any type of machine, component, physical or virtual equipment, computer storage medium or device, or in a propagated signal wave capable of providing instructions or data to or being interpreted by the processing device. The software also may be distributed over network-coupled computer systems so that the software is stored and executed in a distributed fashion. The software and data may be stored by one or more non-transitory computer-readable recording mediums.

The foregoing exemplary embodiments are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. An automated system for testing a semiconductor specimen, the automated system comprising:
a holder configured to hold the semiconductor specimen;
a container configured to hold a reagent;
a gripper configured to grip the holder;
a robot comprising an end effector configured to manipulate the gripper between a gripping mode in which the gripper grips the holder and a release mode in which the gripper releases the holder; and
a test device configured to test the semiconductor specimen, and comprising:
a load area where the container and the holder are loaded;
a processing area where the holder is dipped into the reagent within the container using the end effector and rotated to chemically process the semiconductor specimen;
a rinsing area where the holder and the semiconductor specimen are rinsed using the gripper connected to the end effector; and
a drying area where the holder and the semiconductor specimen are dried using the gripper connected to the end effector.

2. The automated system of claim 1, wherein the gripper comprises:
a gripper base configured to be connected to the end effector;
a plurality of legs extending from the gripper base in an axial direction and being spaced apart from each other around a perimeter of the gripper base in a circumferential direction ; and
a pushrod connected to the plurality of legs and configured to push the plurality of legs, in a radial direction from a center of the gripper base towards an edge of the gripper base.

3. The automated system of claim 2, wherein the pushrod comprises:
a first portion extending from the center of the gripper base in the axial direction; and
a plurality of second portions connecting the first portion and the plurality of legs, respectively, and optionally wherein:
the gripper base comprises a base hole; and
the first portion of the pushrod passes at least partially through the base hole.

4. The automated system of claim 2 or 3, wherein the gripper further comprises grooves arranged in the plurality of legs, respectively, and configured to engage with the holder.

5. The automated system of any preceding claim, wherein the holder comprises:
a holder base; and
a recess in one surface of the holder base and configured to arrange the semiconductor specimen therein, and optionally wherein the holder further comprises an elastically deformable tongue configured to elastically support one side of the semiconductor specimen.

6. The automated system of claim 5, wherein the holder further comprises a clearance gap arranged on the surface of the holder base and connected to the recess.

7. The automated system of any preceding claim, wherein the semiconductor specimen is 18 millimeters (mm) to 22 mm in length and width, and 0.6 mm to 0.9 mm in thickness.

8. The automated system of any preceding claim, wherein the processing area comprises:
a heater configured to increase a temperature in the container; and
a cooler configured to decrease the temperature in the container, and optionally wherein the processing area further comprises a reservoir configured to hold a liquid having a bath temperature, and further optionally wherein the heater comprises a pipe arranged in the reservoir.

9. The automated system of claim 8, wherein the cooler is configured to generate a vortex in the reservoir.

10. The automated system of claim 8 or 9, further comprising:
a processor; and
a memory configured to store at least one instruction executable by the processor,
wherein the at least one instruction comprises an instruction to control either one or both of the heater and the cooler to set the bath temperature to be a test temperature.

11. The automated system of any of claims 8 to 10, wherein the processing area further comprises a level sensor configured to measure a level of the reservoir.

12. The automated system of claim 1, further comprising:
a processor; and
a memory configured to store at least one instruction executable by the processor,
wherein the at least one instruction comprises an instruction to not supply either one or both of a new container and a new holder to the load area while the semiconductor specimen is being processed in the processing area.

13. The automated system of any preceding claim, further comprising:
an optical sensor configured to measure a structure of a surface of the semiconductor specimen.

14. The automated system of any preceding claim, wherein the gripper is attachable to and detachable from the end effector, and the automated system further comprises:
a return area where the gripper is discarded by the end effector.

15. An automated method of testing a semiconductor specimen, the automated method comprising:
providing a holder configured to hold the semiconductor specimen and a container configured to hold a reagent to a load area;
moving the container to a processing area using an end effector;
moving the holder to the processing area using the end effector;
dipping the holder into the reagent within the container and rotating the holder to chemically process the semiconductor specimen;
moving the holder to a rinsing area using the end effector to rinse the semiconductor specimen; and
moving the holder to a drying area using the end effector to dry the semiconductor specimen.
